# FASCICULE DE BREVET EUROPEEN

(11) **EP 0 753 872 B1**
(45) Date de publication et mention de la délivrance du brevet: **31.10.2001**
(21) Numéro de dépôt: 95401675.4
(22) Date de dépôt: 12.07.1995
(51) Int. Cl.: H01H 9/02, F16B 17/00

(54) **Boîtier pour appareil électrique**
Gehäuse für ein elektrisches Gerät
Housing for an electrical apparatus

(43) Date de publication de la demande: 15.01.1997
(73) Titulaire: LEGRAND, F-87000 Limoges (FR); LEGRAND SNC, F-87000 Limoges (FR)
(72) Inventeur: Cottone, Guy, F-06370 Mouans Sartoux (FR)
(74) Mandataire: CABINET BONNET-THIRION

(56) Documents cités:
- EP-A- 0 456 587
- DE-B- 2 748 431
- DE-U- 9 113 246

## Description

La présente invention concerne un boîtier d'appareil électrique selon le préambule de la revendication 1, connu de document FR 2 662 018 (correspondant au document europeen EP 0 456 587).

Cette invention est notamment applicable aux interrupteurs différentiels dont le boîtier comporte généralement un socle qu'un capot est adapté à recouvrir. Pour des raisons de sécurité, les interrupteurs différentiels mis dans le commerce doivent être préférablement indémontables et, en conséquence, leurs boîtiers doivent être assemblés de manière irréversible.

Plus généralement, la présente invention est applicable à tout appareil électrique dont on veut que le boîtier soit assemblé de manière irréversible, tel que interrupteur, télérupteur, boîtier électronique, et autres.

Pour la plupart des appareils électriques de ce genre, et notamment dans le cas des interrupteurs différentiels, des contrôles de fonctionnement doivent être conduits après montage de l'appareil. En principe, ces contrôles doivent être effectués sur l'appareil dans les conditions dans lesquelles il sera utilisé, c'est-à-dire renfermé dans son boîtier. L'assemblage des boîtiers étant irréversible, les appareils ne satisfaisant pas aux contrôles devront être mis au rebut, ce qui constitue un inconvénient grave. C'est le cas notamment du boîtier décrit dans le document DE-B-2 748 431.

Idéalement, un boîtier d'appareil électrique devrait être susceptible tout à la fois d'être démonté s'il n'a pas satisfait aux contrôles de fonctionnement, et d'être rendu indémontable s'il a satisfait auxdits contrôles.

Il a été déjà proposé, dans le brevet français N° 2.662.018, un boîtier de disjoncteur à assemblage définitif assuré par des rivets, et équipé, en outre, d'une vis supplémentaire de préassemblage. Cette vis supplémentaire permet un assemblage provisoire du boîtier adapté au réglage du seuil de déclenchement thermique de la bilame du disjoncteur.

S'agissant du réglage de la bilame d'un disjoncteur, la disposition d'une seule vis de préassemblage à proximité du pied de la bilame suffit. En revanche, si l'on veut, comme on l'a mentionné plus haut, contrôler un appareil électrique dans les conditions dans lesquelles il sera utilisé, il faudrait mettre en oeuvre à proximité de chaque moyen de fixation définitif une vis de préassemblage correspondante. Ceci complique par trop la fabrication de l'appareil électrique en question.

La présente invention vise un boîtier d'appareil électrique, de structure simple, qui, d'une part, autorise le démontage de l'appareil électrique si ce dernier n'a pas satisfait aux contrôles de fonctionnement, et, d'autre part, permet de rendre ledit appareil électrique indémontable après lesdits contrôles.

A cet effet, l'invention propose un boîtier d'appareil électrique constitué d'au moins deux parties complémentaires destinées à être assemblées de manière irréversible pour renfermer les composants électriques et/ou mécaniques dudit appareil, l'une desdites parties du boîtier comportant au moins un moyen d'accrochage mobile adapté à coopérer avec un moyen d'accrochage fixe de l'autre partie pour permettre un assemblage desdites parties du boîtier, caractérisé en ce que l'assemblage par les moyens d'accrochage mobile et fixe est un assemblage réversible, au moins un moyen de butée mobile dans un sens unique étant prévu et adapté à immobiliser ledit moyen d'accrochage mobile en prise avec ledit moyen d'accrochage fixe pour permettre l'assemblage irréversible du boîtier ; et en ce qu'est ménagé un passage accessible de l'extérieur et à travers lequel, lorsque les deux parties du boîtier sont assemblées, peut être commandé le débattement du moyen de butée mobile.

Avant les contrôles de fonctionnement, on assemble les parties du boîtier simplement en mettant en prise les moyens d'accrochage mobile et d'accrochage fixe. Le boîtier peut donc être démonté si l'appareil n'a pas satisfait auxdits contrôles. Si, au contraire, l'appareil fonctionne correctement, il suffit de déplacer le moyen de butée mobile pour interdire toute désolidarisation des moyens d'accrochage fixe et mobile et, par conséquent, rendre ledit appareil indémontable.

Comme on le constate, la présente invention ne met pas en oeuvre des moyens de préassemblage distincts se surajoutant aux moyens d'assemblage définitif, l'accrochage entre les parties du boîtier étant assuré par les mêmes moyens dans le cas de l'assemblage réversible que dans celui de l'assemblage irréversible.

Quant au moyen de butée mobile, il peut être mis en oeuvre sans trop compliquer la structure du boîtier. De la sorte, la combinaison de moyens d'accrochage fixe et mobile avec un moyen de butée mobile peut être beaucoup plus simple à mettre en oeuvre que celle précédemment évoquée de rivets avec une ou plusieurs vis de préassemblage.

Avantageusement, lesdits moyens d'accrochage mobile et fixe coopèrent par encliquetage élastique.

De préférence, une patte élastique, formant moyen d'accrochage mobile, est adaptée à porter contre une pièce d'ancrage, formant moyen d'accrochage fixe, ladite patte élastique comportant à son extrémité un talon adapté à coopérer avec un épaulement de ladite pièce d'ancrage pour permettre l'accrochage de ladite patte avec ladite pièce d'ancrage ; ladite patte et ladite pièce d'ancrage viennent de moulage avec respectivement l'une et l'autre parties du boîtier.

Avantageusement, en regard de ladite pièce d'ancrage est prévu un logement dans lequel ladite patte élastique peut se débattre entre une position accrochée et une position libre, ledit logement étant adapté à recevoir un pion, formant moyen de butée mobile, adapté à être encastré irréversiblement entre ladite patte et au moins une paroi dudit logement, de manière à immobiliser ladite patte dans sa position accrochée ; de préférence l'épaisseur dudit pion avant encastrement est supérieure à l'espace laissé libre par ladite patte élastique dans ledit logement.

Avantageusement, ledit pion vient de moulage avec la partie du boîtier portant ladite pièce d'ancrage, une fine toile de matière reliant ledit pion au reste de ladite partie, de manière à ce qu'il puisse en être détaché par l'application d'une légère contrainte. Une telle disposition est du genre de celle décrite dans le document DE-U-91 13 246 pour assembler, de façon automatique, deux pièces en matière plastique définitivement, la libération des deux pièces étant impossible sans destruction.

Avantageusement, est ménagé un passage accessible de l'extérieur et à travers lequel, lorsque les deux parties du boîtier sont assemblées, peut être commandé le débattement du moyen d'accrochage mobile.

De préférence, le passage accessible de l'extérieur, et à travers lequel peut être commandé le débattement du moyen d'accrochage mobile, s'étend perpendiculairement au logement en dessous de l'épaulement.

Avantageusement, ledit boîtier est constitué d'un socle creux et d'un capot adapté à recouvrir ledit socle, un des côtés dudit capot pouvant être solidarisé avec ledit socle de sorte que lesdits socle et capot soient en liaison pivot, l'autre côté du capot portant ledit moyen d'accrochage mobile adapté à coopérer avec ledit moyen d'accrochage fixe porté par le côté correspondant du socle ; de préférence, des moyens d'emboîtement de formes complémentaires viennent de moulage respectivement sur ledit socle et sur ledit capot, lesdits moyens d'emboîtement étant adaptés à solidariser en liaison pivot le capot sur le socle.

Avantageusement, un ergot porté par une partie est adapté à être en prise avec un trou borgne prévu dans l'autre partie pour empêcher toute translation transversale de l'une par rapport à l'autre.

Ces aspects de l'invention et d'autres caractéristiques et avantages ressortiront d'ailleurs de la description qui va suivre, en référence aux dessins annexés parmi lesquels:
la figure 1 est une vue en élévation, avec des arrachements locaux, d'un boîtier d'appareil électrique suivant la présente invention, les deux parties de ce boîtier n'étant pas assemblées;
la figure 2 est une vue agrandie d'une partie II de la figure 1 ;
la figure 3 est une vue similaire à celle de la figure 1, les deux parties du boîtier étant assemblées de manière réversible ;
la figure 4 est une vue agrandie d'une partie IV de la figure 3 ;
la figure 5 est une vue similaire à celle de la figure 1, les deux parties du boîtier étant assemblées de manière irréversible ; et
la figure 6 est une vue agrandie d'une partie V de la figure 5.

Un boîtier 1 est constitué d'un socle creux 2 adapté à être recouvert par un capot 3 pour renfermer les composants électriques et mécaniques, non représentés, d'un interrupteur différentiel. Cet interrupteur est du genre décrit dans le brevet N° 9200452 déposé le 17 janvier 1992.

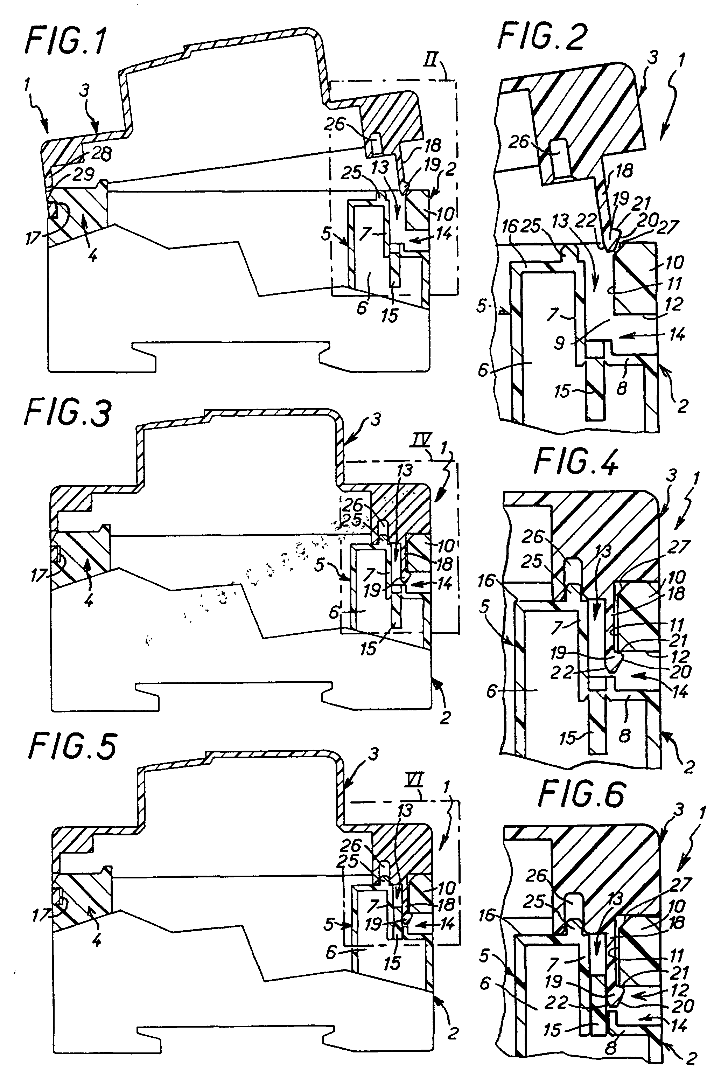

De manière bien connue en soi, le socle 2 est en forme de boîte globalement parallèlépipédique, sa base étant de forme adaptée à la disposition dudit boîtier sur un rail normalisé. De manière également bien connue, le capot 3 est en forme de couvercle, complémentaire de celle du socle 2, comme on le voit, par exemple, sur la figure 3. Le socle 2 est moulé et monobloc. Il en va de même pour le capot 3.

L'aménagement intérieur du boîtier 1, permettant l'installation et le maintien des différents composants électriques et mécaniques de l'interrupteur différentiel, ne relevant pas de la présente invention, il ne sera pas décrit en détail ici. Il suffira d'indiquer que l'interrupteur comporte, de part et d'autre du boîtier 1, une paire de bornes de sortie et une paire de bornes d'entrée. Les deux bornes de chacune de ces paires de bornes sont installées dans des logements respectifs du socle 2 qui sont prolongés dans le capot 3. Dans le socle 2 les logements des bornes de l'une et l'autre paires de bornes sont séparés par des cloisons'respectives 4 et 5, s'étendant longitudinalement et verticalement dans la représentation de la figure 1. La coupe du boîtier 1, que l'on voit au niveau: des arrachements locaux de cette figure, passe par l'intérieur de ces cloisons 4 et 5.

Comme on le voit, par exemple, sur la figure 1, la cloison 5 est creuse, délimitant intérieurement un compartiment 6. A l'intérieur de ce compartiment, deux cloisons transversales 7 et 8, s'étendant l'une verticalement et l'autre horizontalement, délimitent un sous-compartiment 9 (voir figure 2), au coin supérieur droit du compartiment 6 tel que représenté. Comme on le voit sur la figure 2, le coin supérieur droit du sous-compartiment 9, est occupé par une surépaisseur 10 de section carrée s'étendant transversalement. Comme il apparaîtra mieux par la suite, cette surépaisseur fait office de pièce d'ancrage pour l'assemblage du capot 3 sur le socle 2.

Comme on le voit sur la figure 2, cette pièce d'ancrage 10 définit, à l'intérieur du sous-compartiment 9, d'une part une surface verticale 11, et, d'autre part, une surface horizontale 12, formant épaulement, s'étendant au niveau d'une portion inférieure de ce sous-compartiment 9. Ainsi, entre la surface d'appui 11 et la cloison transversale verticale 7 est défini un logement vertical 13, alors que, en dessous de l'épaulement 12, s'étend un passage horizontal 14 également délimité par la cloison transversale horizontale 8. Comme on le voit sur la figure 1, ce passage horizontal 14 traverse la paroi extérieure droite de l'interrupteur différentiel.

Sur l'angle supérieur gauche de la pièce d'ancrage 10, dans la représentation de la figure 2, est ménagé un chanfrein 27 incliné vers le bas et la gauche.

Comme on le voit bien sur la figure 2, les cloisons transversales verticale 7 et horizontale 8 ne se touchent pas. Leurs extrémités respectives, en regard l'une de l'autre, sont suffisamment espacées pour être adaptées à recevoir entre elles l'extrémité supérieure d'un pion 15, de forme parallèlépipédique. Avantageusement, ce pion 15 vient de moulage avec le socle 2, une fine toile de matière reliant l'extrémité supérieure dudit pion aux extrémités respectives des cloisons transversales verticale 7 et horizontale 8. La quantité de matière formant cette toile est choisie de manière à ce que l'application d'une légère contrainte suffise à rompre cette toile et libérer ledit pion.

Le compartiment 6, dont l'aménagement de la partie supérieure vient d'être décrit, s'étend vers le bas jusqu'à la base du socle 2, de manière à ce que l'extrémité inférieure du pion 15 soit accessible de l'extérieur du boîtier, au moyen d'un outil adapté à cet effet. A son extrémité supérieure, ce compartiment 6 est fermé, d'une part, par une cloison transversale horizontale 16 dont l'extrémité est prolongée par la cloison verticale 7, et, d'autre part, par la pièce d'ancrage 10. En revanche, le logement vertical 13 se trouvant entre la cloison verticale 7 et la pièce d'ancrage 10 est ouvert vers le haut.

Au dessus de la cloison horizontale supérieure 16 est formé un ergot 25, s'étendant vers le haut, adapté à être en prise avec un trou borgne 26 du capot 3.

Sur le côté du socle 2 opposé à celui au niveau duquel se trouve la cloison 5, dont l'aménagement intérieur vient d'être décrit, est ménagée une rainure 17, s'étendant transversalement à l'extérieur dudit socle, à proximité du plan de jonction avec le capot 3 (figure 1).

Comme on le voit sur la figure 1, d'un côté du capot 3 vient de moulage une patte 18, s'étendant vers le bas. L'épaisseur de cette patte et le matériau à partir duquel elle est réalisée confèrent à ladite patte présente une certaine élasticité permettant sa participation à un accrochage par encliquetage élastique, qui sera décrit plus en détail par la suite. Par ailleurs, cette patte 18 se termine à son extrémité inférieure par un talon 19, d'épaisseur supérieure au reste de ladite patte. Ce talon comporte, sur son côté tourné vers la droite dans la représentation de la figure 2, un bord d'attaque 20 incliné, de sorte que ledit talon va en s'évasant vers le haut jusqu'à un bord de fuite 21 sensiblement perpendiculaire à la direction d'extension de la patte 18. Enfin, sur l'extrémité inférieure gauche du talon dans la représentation de la figure 2, est ménagé un chanfrein formant rampe 22 inclinée vers le haut et la gauche.

Le capot 3, à l'opposé de son côté portant la patte 18, présente une paroi verticale 28 s'étendant vers le bas (figure 1). Une rainure 29, transversale, est ménagée au niveau de la partie inférieure de cette paroi 28, à proximité du plan de jonction avec le socle 2. Cette paroi 28 a une épaisseur suffisante pour présenter une bonne rigidité. Elle est, en effet, destinée, comme on le verra mieux par la suite, à participer à un accrochage rigide et non, comme la patte 18, à un accrochage par encliquetage élastique.

Le socle 2 et le capot 3 qui viennent d'être décrits peuvent être assemblés, pour former le boîtier 1, de la façon qui va maintenant être décrite.

La portion de la paroi 28 du capot 3 se trouvant en dessous de la rainure 29 est introduite dans la rainure 17 du socle 2, la partie de ce socle qui est au dessus de cette rainure 17 s'installant alors dans ladite rainure 29. L'emboîtement ainsi réalisé se fait avec un léger jeu, de sorte qu'une rotation d'axe transversal est possible. Autrement dit, le capot 3 est ainsi monté pivotant sur le socle 2.

Le capot 3 et le socle 2 étant dans la disposition représentée à la figure 1, ils sont alors amenés dans la position représentée à la figure 3 par pivotement du capot 3 vers le socle 2. Le bord d'attaque 20 du talon 19 va alors porter contre le chanfrein 27 de la pièce d'ancrage 10. Ceci a pour effet de déformer élastiquement la patte 18 vers la gauche (dans la représentation de la figure 1). Cette patte 18 va alors s'introduire dans le logement vertical 13, en portant contre la surface verticale 11 de la pièce d'ancrage. Lorsque le bord de fuite 21 du talon 19 se présente au niveau de l'épaulement 12, la patte 18 va revenir vers la droite et se trouver dans la position représentée aux figures 3 et 4, ladite patte s'étendant contre la surface verticale 11 de la pièce d'ancrage et le talon 19 se trouvant sous l'épaulement 12 de ladite pièce d'ancrage. De la sorte, la patte 18, formant moyen d'accrochage mobile, se trouve en prise avec la pièce d'ancrage 10, formant moyen d'accrochage fixe, assurant ainsi, en coopération avec l'emboîtement réalisé de l'autre côté du boîtier qui a été décrit précédemment, l'assemblage du capot 3 sur le socle 2.

L'ergot 25 en prise avec le trou borgne 26 contribue à cet assemblage en empêchant toute translation longitudinale ou transversale du capot 3 par rapport au socle 2.

L'assemblage ainsi réalisé est réversible. En effet, il suffit d'introduire dans le passage horizontal 14 un outil adapté à cet effet et de pousser le talon 19 jusqu'à le décrocher de la pièce d'ancrage 10, pour pouvoir faire pivoter le capot 3 vers sa position de la figure 1.

Pour rendre l'assemblage représenté aux figures 3 et 4 irréversible, il suffit d'introduire, par le bas, dans le compartiment 6, un outil adapté à cet effet, et d'exercer sur l'extrémité basse du pion 15 une contrainte de poussée vers le haut suffisante pour rompre la toile de matière le liant au socle 2 et le faire pénétrer dans le logement vertical 13.

L'épaisseur du pion 15 est supérieure à l'espace laissé libre entre la cloison transversale verticale 7 et la patte 18. En arrivant au niveau de la rampe 22, le pion 15 est donc déformé par écrasement, son introduction dans le logement 13 se faisant à force.

Lorsque le pion 15 est entièrement introduit dans le logement 13 (figure 5 et 6), c'est-à-dire lorsque son extrémité inférieure se trouve dans l'alignement de la cloison transversale horizontale 8, il s'y trouve encastré de façon irréversible du fait de la déformation qu'il a subi au cours de son introduction.

Une fois ce pion 15 introduit dans le logement 13, la patte mobile 18 est immobilisée dans sa position d'accrochage avec la pièce d'ancrage fixe 10. Ainsi, le pion 15 joue ici le rôle d'un moyen de butée mobile dont le déplacement conduit à bloquer la patte mobile 18, ce qui immobilise l'accrochage de cette patte mobile avec la pièce d'ancrage 10. Le déplacement de ce pion 15 est à sens unique, puisque, une fois introduit dans le logement vertical 13, il ne peut plus en sortir. Cela conduit à rendre irréversible l'assemblage du capot 3 sur le socle 2.

Avantageusement, pour parfaire l'assemblage qui vient d'être décrit, des épaulements de formes complémentaires (non représentés) sont ménagés respectivement sur les grands côtés longitudinaux du socle et sur les côtés correspondants du capot, au niveau de leur jonction, de manière à permettre un emboîtement dudit socle dans ledit capot au niveau de ces grands côtés.

Bien entendu, la présente invention ne se limite pas à la forme de réalisation décrite et représentée, mais englobe toute variante d'exécution et d'application.

Par exemple, le moyen de butée mobile peut être constitué par une patte articulée autour d'un axe transversal du capot 3 sur lequel intervient un ressort de rappel axial adapté à solliciter ladite patte vers la pièce d'ancrage 10.

Egalement, le boîtier peut être pourvu de plusieurs couples de moyens d'accrochage fixe et mobile, coopérant avec des moyens de butée mobiles respectifs, du genre qui vient d'être décrit. Notamment, l'emboîtement intervenant du côté gauche du boîtier dans la représentation de la figure 2 peut être remplacé par un tel accrochage.

## Revendications

1. Boîtier d'appareil électrique constitué d'au moins deux parties complémentaires destinées à être assemblées de manière irréversible pour renfermer les composants électriques et/ou mécaniques dudit appareil, l'une desdites parties (3) du boîtier (1) comportant au moins un moyen d'accrochage mobile (18) adapté à coopérer avec un moyen d'accrochage fixe (10) de l'autre partie (2) pour permettre un assemblage desdites parties du boîtier, **caractérisé en ce que** l'assemblage par les moyens d'accrochage mobile (18) et fixe (10) est un assemblage réversible, au moins un moyen de butée (15) mobile dans un sens unique étant prévu et adapté à immobiliser ledit moyen d'accrochage mobile en prise avec ledit moyen d'accrochage fixe pour permettre l'assemblage irréversible du boîtier ; et **en ce qu'**est ménagé un passage (6) accessible de l'extérieur et à travers lequel, lorsque les deux parties (2,3) du boîtier (1) sont assemblées, peut être commandé le débattement du moyen de butée mobile (15).

2. Boîtier d'appareil électrique selon la revendication 1, **caractérisé en ce que** lesdits moyens d'accrochage mobile (18) et fixe (10) coopèrent par encliquetage élastique.

3. Boîtier d'appareil électrique selon la revendication 2, **caractérisé en ce qu'**une patte élastique (18), formant moyen d'accrochage mobile, est adaptée à porter contre une pièce d'ancrage (10), formant moyen d'accrochage fixe, ladite patte élastique comportant à son extrémité un talon (19) adapté à coopérer avec un épaulement (12) de ladite pièce d'ancrage pour permettre l'accrochage de ladite patte avec ladite pièce d'ancrage.

4. Boîtier d'appareil selon la revendication 3, **caractérisé en ce que** ladite patte (18) et ladite pièce d'ancrage (10) viennent de moulage avec respectivement l'une (3) et l'autre (2) parties du boîtier.

5. Boîtier d'appareil électrique selon la revendication 3 ou 4, **caractérisé en ce qu'**en regard de ladite pièce d'ancrage (10) est prévu un logement (13) dans lequel ladite patte élastique (18) peut se débattre entre une position accrochée et une position libre, ledit logement étant adapté à recevoir un pion (15), formant moyen de butée mobile, adapté à être encastré irréversiblement entre ladite patte et au moins une paroi (7) dudit logement, de manière à immobiliser ladite patte dans sa position accrochée.

6. Boîtier d'appareil électrique selon la revendication 5, **caractérisé en ce que** l'épaisseur dudit pion (15) avant encastrement est supérieure à l'espace laissé libre par ladite patte élastique (18) dans ledit logement (13).

7. Boîtier d'appareil électrique selon l'une des revendications 5 ou 6, **caractérisé en ce que** ledit pion (15) vient de moulage avec la partie (2) du boîtier (1) portant ladite pièce d'ancrage (10), une fine toile de matière reliant ledit pion au reste de ladite partie, de manière à ce qu'il puisse en être détaché par l'application d'une légère contrainte.

8. Boîtier d'appareil électrique selon l'une quelconque des revendications précédentes, **caractérisé en ce qu'**est ménagé un passage (14) accessible de l'extérieur et à travers lequel, lorsque les deux parties (2,3) du boîtier (1) sont assemblées, peut être commandé le débattement du moyen d'accrochage mobile (18).

9. Boîtier d'appareil électrique selon les revendications 5 et 8, **caractérisé en ce que** le passage (14) accessible de l'extérieur, et à travers lequel peut être commandé le débattement du moyen d'accrochage mobile (18), s'étend perpendiculairement au logement (13) en dessous de l'épaulement (12).

10. Boîtier d'appareil électrique selon l'une quelconque des revendications précédentes, **caractérisé en ce que** ledit boîtier (1) est constitué d'un socle creux (2) et d'un capot (3) adapté à recouvrir ledit socle, un des côtés dudit capot pouvant être solidarisé avec ledit socle de sorte que lesdits socle et capot soient en liaison pivot, l'autre côté du capot portant ledit moyen d'accrochage mobile (18) adapté à coopérer avec ledit moyen d'accrochage fixe (10) porté par le côté correspondant du socle.

11. Boîtier d'appareil électrique selon la revendication 10, **caractérisé en ce que** des moyens d'emboîtement (17,29) de formes complémentaires viennent de moulage respectivement sur ledit socle (2) et sur ledit capot (3), lesdits moyens d'emboîtement étant adaptés à solidariser en liaison pivot le capot sur le socle.

12. Boîtier d'appareil électrique selon l'une quelconque des revendications précédentes, **caractérisé en ce qu'**un ergot (25) porté par une partie (2) est adapté à être en prise avec un trou borgne (26) prévu dans l'autre partie (3) pour empêcher toute translation transversale de l'une (2) par rapport à l'autre (3).

## Patentansprüche

1. Gehäuse für ein elektrisches Gerät, bestehend aus mindestens zwei ergänzenden Teilen, die dazu bestimmt sind, irreversibel zusammengebaut zu werden, um die elektrischen und/oder mechanischen Bauteile des Geräts einzuschließen, wobei einer (3) der Teile des Gehäuses (1) mindestens ein bewegliches Einhakmittel (18) aufweist, das dafür ausgelegt ist, mit einem feststehenden Einhakmittel (10) des anderen Teils (2) zusammenzuwirken, um einen Zusammenbau dieser Teile des Gehäuses zu gestatten, **dadurch gekennzeichnet, dass** der Zusammenbau durch das bewegliche Einhakmittel (18) und das feststehende Einhakmittel (10) ein reversibler Zusammenbau ist, wobei mindestens ein nur in einer Richtung bewegliches Anschlagsmittel (15) vorgesehen ist und dazu ausgelegt ist, das mit dem feststehenden Einhakmittel in Eingriff stehende bewegliche Einhakmittel zu blockieren, um den irreversiblen Zusammenbau des Gehäuses zu gestatten, und dass ein von außen zugänglicher Durchgang (6) vorgesehen ist, über den, wenn die beiden Teile (2, 3) des Gehäuses (1) zusammengebaut sind, die Bewegung des beweglichen Anschlagsmittels (15) bewirkt werden kann.

2. Gehäuse für ein elektrisches Gerät nach Anspruch 1, **dadurch gekennzeichnet, dass** das bewegliche Einhakmittel (18) und das feststehende Einhakmittel (10) durch elastische Einrastung zusammenwirken.

3. Gehäuse für ein elektrisches Gerät nach Anspruch 2, **dadurch gekennzeichnet, dass** ein das bewegliche Einhakmittel bildender elastischer Lappen (18) dafür ausgelegt ist, an einem das feststehende Einhakmittel bildenden Verankerungsteil (10) anzuliegen, wobei der elastische Lappen an seinem Ende eine Nase (19) aufweist, die dafür ausgelegt ist, mit einer Schulter (12) des Verankerungsteils zusammenzuwirken, um die Verhakung des Lappens mit dem Verankerungsteil zu gestatten.

4. Gehäuse für ein elektrisches Gerät nach Anspruch 3, **dadurch gekennzeichnet, dass** der Lappen (18) und das Verankerungsteil (10) mit dem einen (3) bzw. mit dem anderen (2) der Teile des Gehäuses einstückig geformt sind.

5. Gehäuse für ein elektrisches Gerät nach Anspruch 3 oder 4, **dadurch gekennzeichnet, dass** vor dem Verankerungsteil (10) eine Aufnahme (13) vorgesehen ist, in der sich der elastische Lappen (18) zwischen einer eingehakten Stellung und einer freien Stellung bewegen kann, wobei diese Aufnahme dafür ausgelegt ist, einen das bewegliche Anschlagsmittel bildenden Stift (15) aufzunehmen, der dafür ausgelegt ist, zwischen dem Lappen und mindestens einer Wand (7) der Aufnahme irreversibel eingelassen zu werden, so dass der Lappen in seiner eingehakten Stellung blockiert wird.

6. Gehäuse für ein elektrisches Gerät nach Anspruch 5, **dadurch gekennzeichnet, dass** die Dicke des Stifts (15) vor dem Einlassen größer als der Raum ist, der von dem elastischen Lappen (18) in der Aufnahme (13) freigelassen wird.

7. Gehäuse für ein elektrisches Gerät nach einem der Ansprüche 5 oder 6, **dadurch gekennzeichnet, dass** der Stift (15) mit dem das Verankerungsteil (10) tragenden Teil (2) des Gehäuses (1) einstückig geformt ist, wobei eine dünne Werkstoffwand diesen Stift mit dem Rest dieses Teils verbindet, so dass er durch Ausüben einer leichten Spannung abgetrennt werden kann.

8. Gehäuse für ein elektrisches Gerät nach einem der vorhergehenden Ansprüche, **dadurch gekennzeichnet, dass** ein von außen zugänglicher Durchgang (14) vorgesehen ist, über den, wenn die beiden Teile (2, 3) des Gehäuses (1) zusammengebaut sind, die Bewegung des beweglichen Einhakmittels (18) bewirkt werden können.

9. Gehäuse für ein elektrisches Gerät nach den Ansprüchen 5 und 8, **dadurch gekennzeichnet, dass** der von außen zugängliche Durchgang (14), über den die Bewegung des beweglichen Einhakmittels (18) bewirkt werden kann, sich senkrecht zu der Aufnahme (13) unter der Schulter (12) erstreckt.

10. Gehäuse für ein elektrisches Gerät nach einem der vorhergehenden Ansprüche, **dadurch gekennzeichnet, dass** das Gehäuse (1) aus einem hohlen Sockel (2) und einer Kappe (3) besteht, die dafür ausgelegt ist, den Sockel zu bedecken, wobei eine der Seiten der Kappe mit dem Sockel so fest verbunden werden kann, dass der Sockel und die Kappe in Schwenkverbindung sind, wobei die andere Seite der Kappe das bewegliche Einhakmittel (18) trägt, das dafür ausgelegt ist, mit dem von der entsprechenden Seite des Sockels getragenen feststehenden Einhakmittel (10) zusammenzuwirken.

11. Gehäuse Für ein elektrisches Gerät nach Anspruch 10, **dadurch gekennzeichnet, dass** Ineinandersteckmittel (17, 29) mit ergänzenden Formen mit dem Sockel (2) bzw. mit der Kappe (3) einstückig mitgeformt sind, wobei diese Ineinandersteckmittel dafür ausgelegt sind, die Kappe auf dem Sockel in einer Schwenkverbindung anzubringen.

12. Gehäuse für ein elektrisches Gerät nach einem der vorhergehenden Ansprüche, **dadurch gekennzeichnet, dass** ein von einem Teil (2) getragener Vorsprung (25) dafür ausgelegt ist, mit einem in dem anderen Teil (3) vorgesehenen Sackloch (26) in Eingriff zu kommen, um jede Quertranslation des einen (2) bezüglich des anderen (3) zu verhindern.

## Claims

1. An electrical apparatus casing formed by at least two complementary portions intended to be irreversibly assembled to enclose the electrical and/or mechanical components of said apparatus, one of said portions (3) of the casing (1) comprising at least one movable hooking means (18) adapted to co-operate with a fixed hooking means (10) of the other portion (2) to permit said portions of the casing to be assembled, **characterised in that** assembly by the movable and fixed hooking means (18 and 10) is reversible assembly, at least one abutment means (15) movable in a single direction being provided and adapted to immobilise said movable hooking means in engagement with said fixed hooking means to permit irreversible assembly of the casing; and that there is provided a passage (6) which is accessible from the exterior and through which, when the two portions (2, 3) of the casing (1) are assembled, the movement of the mobile abutment means (15) can be controlled.

2. An electrical apparatus casing according to claim 1 **characterised in that** said movable and fixed hooking means (18 and 10) co-operate by resilient latching engagement.

3. An electrical apparatus casing according to claim 2 **characterised in that** a resilient tongue (18) forming a movable hooking means is adapted to bear against an anchoring portion (10) forming the fixed hooking means, said resilient tongue comprising at its end a lug (19) adapted to co-operate with a shoulder (12) of said anchoring portion to permit hooking engagement of said tongue with said anchoring portion.

4. An electrical apparatus casing according to claim 3 **characterised in that** said tongue (18) and said anchoring portion (10) are moulded with one portion (3) and the other portion (2) respectively of the casing.

5. An electrical apparatus casing according to claim 3 or claim 4 **characterised in that** disposed facing said anchoring portion (10) is a housing (13) in which said resilient tongue (18) can move between a hooked position and a free position, said housing being adapted to receive a pin portion (15) forming the movable abutment means adapted to be irreversibly inserted between said tongue and at least one wall (7) of said housing in such a way as to immobilise said tongue in its hooked position.

6. An electrical apparatus casing according to claim 5 **characterised in that** the thickness of said pin portion (15) prior to insertion is greater than the space left free by said resilient tongue (18) in said housing (13).

7. An electrical apparatus casing according to one of claims 5 and 6 **characterised in that** said pin portion (15) is moulded with the portion (2) of the casing (1) carrying said anchoring portion (10), a thin web of material connecting said pin portion to the rest of said portion (2) in such a way that said pin portion can be detached from said portion (2) by the application of a slight force.

8. An electrical apparatus casing according to any one of the preceding claims **characterised in that** there is provided a passage (14) which is accessible from the exterior and through which, when the two portions (2, 3) of the casing (1) are assembled, the movement of the movable hooking means (18) can be controlled.

9. An electrical apparatus casing according to claims 5 and 8 **characterised in that** the passage (14) which is accessible from the exterior and through which the movement of the movable hooking means (18) can be controlled extends perpendicularly to the housing (13) below the shoulder (12).

10. An electrical apparatus casing according to any one of the preceding claims **characterised in that** said casing (1) is formed by a hollow base (2) and a cap (3) adapted to cover said base, one of the sides of which cap can be fixed with respect to said base in such a way that said base and said cap are pivotably connected, the other side of the cap carrying said movable hooking means (18) adapted to co-operate with said fixed hooking means (10) carried by the corresponding side of the base.

11. An electrical apparatus casing according to claim 10 **characterised in that** engagement means (17, 29) of complementary shapes are respectively moulded on said base (2) and on said cap (3), said engagement means being adapted to pivotably mount the cap to the base.

12. An electrical apparatus casing according to any one of the preceding claims **characterised in that** a lug (25) carried by a portion (2) is adapted to be in engagement with a blind hole (26) provided in the other portion (3) to prevent any transverse translatory movement of one portion (2) with respect to the other portion (3).
